# EUROPEAN PATENT SPECIFICATION

(11) **EP 1 898 470 B1**
(45) Date of publication and mention of the grant of the patent: **27.07.2011**
(21) Application number: 07016804.2
(22) Date of filing: 28.08.2007
(51) Int. Cl.: H01L 31/048, B32B 27/32

(54) **Use of a back sheet for photovoltaic modules and resulting photovoltaic module**
Benutzung einer Rückplatte für Photovoltaikmodule und Photovoltaikmodule damit
Utilisation d'une feuille de fond pour modules photovoltaïques et module photovoltaïque en resultant

(30) Priority: 30.08.2006 JP 2006234616; 31.08.2006 JP 2006236929; 30.03.2007 JP 2007094684; 30.03.2007 JP 2007095000
(43) Date of publication of application: 12.03.2008
(73) Proprietor: Keiwa Inc., Osaka-shi Osaka (JP)
(72) Inventor: Kawashima, Koji, Osaka-shi Osaka, 533-0005 (JP)
(74) Representative: Maxton Langmaack & Partner

(56) References cited:
- JP-A- 11 261 085
- US-A- 5 728 230
- US-A1- 2003 070 706
- US-A1- 2006 166 023
- US-B1- 6 323 416

## Description

### BACKGROUND OF THE INVENTION

### Field of Invention

The present invention relates to a back sheet for photovoltaic modules that are the component unit of solar batteries, and a photovoltaic module using the same. More particularly, the present invention relates to a back sheet for photovoltaic modules that is excellent in adhesiveness of a filler layer and in resistance to hydrolysis, voltage endurance, gas barrier properties, heat resistance, weather resistance, durability, toughness and other various characteristics, and that has favorable manufacturability and cost reduction capability.

### Description of the Related Art

In recent years, solar photovoltaic generation as a clean energy source has drawn attention owing to growing concern to environmental problems such as global warming, thereby leading to development of solar batteries having a variety of configurations. This solar battery is produced by packaging a plurality of photovoltaic cells generally wired in series or in parallel, and is constructed with a plurality of unitized photovoltaic modules.

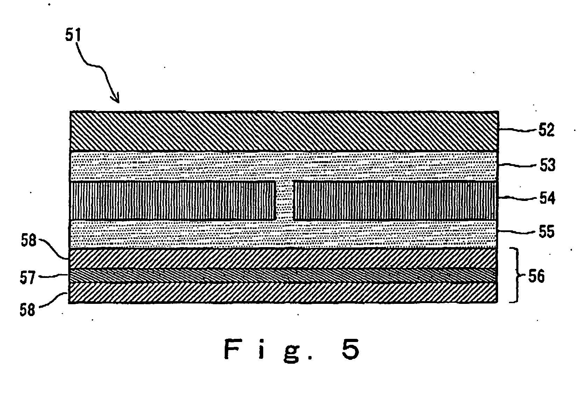

For the aforementioned photovoltaic modules, sufficient durability, weather resistance and the like for permitting use out of doors for a long period of time are needed. As shown in Fig. 5, in a specific structure of a general photovoltaic module 51, a light-transmissive substrate 52 consisting of glass or the like, a filler layer 53 consisting of a thermoplastic resin such as an ethylene-vinyl acetate copolymer (EVA) or the like, a plurality of photovoltaic cells 54 as a photovoltaic device, a filler layer 55 that is similar to the filler layer 53, and a back sheet 56 for photovoltaic modules which are laminated in this order, and molded integrally by a vacuum heat lamination process or the like.

In the photovoltaic module, detachment and discoloration of the filler layers 53 and 55, corrosion of the wiring, deterioration of functions of the photovoltaic cell 54 may be caused when water vapor, oxygen gas or the like infiltrates inside. Therefore, according to the back sheet 56 for photovoltaic modules described above, gas barrier properties against, water vapor, oxygen gas and the like are needed in addition to basic performances such as strength, weather resistance, heat resistance and the like. Also, these days, in order to reduce the loss of power generation efficiency, system voltage of the photovoltaic system is likely to be increased as great as possible, whereby demands for photovoltaic systems having a system voltage not lower than 1000 v have been expanded. Therefore, the back sheet 56 for photovoltaic modules requires greater voltage endurance.

In the conventional back sheet 56 for photovoltaic modules, multilayered structure has been employed in which a pair of synthetic resin layers 58 is laminated on the front face and the back face of the gas barrier layer 57. Specific examples of developed conventional back sheet 56 for photovoltaic modules include (a) those having a structure in which a pair of polyvinyl fluoride films are laminated on both faces of an aluminum foil (see, Japanese Unexamined Patent Application Publication No. Hei 6-177412 and the like); (b) those having a structure in which a polyethylene terephthalate film is laminated on both faces of a resin film on which a metal oxide is vapor deposited (Japanese Unexamined Patent Application Publication No. 2002-100788); and the like.

In the aforementioned back sheet for photovoltaic modules (a), the polyvinyl fluoride film (Tedlar® film) laminated on both faces of the aluminum foil inhibits achievement of durability and price reduction because of this film having low mechanical strength and being expensive. Also, the back sheet for photovoltaic modules (a) is disadvantageous in insufficient voltage endurance resulting from the aluminum foil for use in imparting gas barrier properties.

Since the aforementioned back sheet for photovoltaic modules (b) uses a polyethylene terephthalate film in place of the polyvinyl fluoride film, and a deposited film of a metal oxide in place of the aluminum foil, mechanical strength, cost reduction capability, productivity and voltage endurance are improved as compared with the back sheet for photovoltaic modules (a). However, inferior adhesiveness between the filler layer 55 usually including an ethylene-vinyl acetate copolymer (EVA) and the polyethylene terephthalate film on the front face side is inferior accounts for promotion of inferior durability and decreased life of the photovoltaic module.

In attempts to improve the adhesiveness, techniques of subjecting the surface of the front face side of the polyethylene terephthalate film to a primer treatment, and of replacing the polyethylene terephthalate film on the front face side with the ethylene-vinyl acetate copolymer (EVA) film was developed. However, they cannot have fulfilled the demands for the photovoltaic module, i.e., extension of usable time period, and price reduction because increase in the production cost is caused, and the ethylene-vinyl acetate copolymer (EVA) film is comparatively greatly deteriorated by moisture (hydrolysable property).

US 2006/0 166 023 A1 discloses a back sheet for photovoltaic modules whereby outer layers of the backsheet are made from polyolefin polymers. In example B5 a backsheet is described comprising in the following order: a black polypropylene resin film, a PET-film having a thickness of 50 µm, a PET-film having a thickness of 12 µm, a silicon oxide vapor-deposited film with a thickness of 800 angstrom and a white colored polypropylene resin film. The white colored polypropylene resin film is faced inside in a solar battery module.

### SUMMARY OF THE INVENTION

The present invention was made taking account these above mentioned disadvantages, and an object of the present invention is to provide a back sheet for photovoltaic modules that is excellent in various characteristics such as weather resistance, durability, water resistance, heat resistance, gas barrier properties, toughness and the like, and is particularly excellent in adhesiveness to the filler layer and in resistance to hydrolysis and voltage endurance, and that has favorable manufacturability and cost reduction capability, and a photovoltaic module using the same.

The invention made for solving the aforementioned problems is directed to the use of a back sheet for photovoltaic modules and according to the features of claim 1 and to a photovoltaic module according to claim 8.

Since the front face side resin film includes polyolefin as a principal component in the back sheet for photovoltaic modules, it is excellent in adhesiveness with the ethylene-vinyl acetate copolymer (EVA) generally used in the filler layer, and has favorable resistance to hydrolysis. Therefore, the back sheet for photovoltaic modules can improve durability of the photovoltaic modules, and can promote extension of usable time period of the photovoltaic modules socially demanded.

The barrier film may have a substrate film and an inorganic oxide layer. By thus having a barrier film including an inorganic oxide layer laminated on the substrate film, high gas barrier properties are achieved, and the mechanical strength, cost reduction capability, productivity and voltage endurance can be enhanced as compared with conventional back sheets for photovoltaic modules in which a metal foil is used.

In addition, an aluminum foil may be used as the barrier film. By thus having the barrier film consisting of an aluminum foil, the gas barrier properties of the back sheet for photovoltaic modules can be enhanced.

In the back sheet for photovoltaic modules, a voltage endurable film may be provided between the front face side resin film and the barrier film. By thus having the voltage endurable film laminated between the front face side resin film and the barrier film, the voltage endurance of the back sheet for photovoltaic modules is improved, and regulation of the thickness of the voltage endurable film can effectively meet with increase in system voltages of the photovoltaic system.

Each film (front face side resin film, voltage endurable film, barrier film and back face side resin film) constructing the laminate described above may be laminated via an adhesive layer. By thus laminating each constructional film via an adhesive layer, improvement of the strength, durability, toughness and the like of the back sheet for photovoltaic modules is achieved, and sealing and protecting functions are performed to compensate for defects of the inorganic oxide layer.

A polyurethane-based adhesive may be used as the adhesive that constitutes the adhesive layer. By thus using a polyurethane-based adhesive, decrease in adhesive strength of the barrier sheet and delamination resulting from long-term use of the back sheet for photovoltaic modules out of doors can be prevented, whereby deterioration of the adhesive layer such as yellowing can be further diminished.

The polyolefin used as a principal material component for forming the front face side resin film is polyethylene. The polyethylene has high adhesiveness to the ethylene-vinyl acetate copolymer (EVA) generally used in the filler layer of the photovoltaic module, and additionally, exhibits favorable balance of costs and various functions such as resistance to hydrolysis, heat resistance, weather resistance and the like.

The back face side resin film may include polyethylene naphthalate or polyethylene terephthalate as a principal component. Since the polyethylene terephthalate is inexpensive and has various functions such as excellent heat resistance, voltage endurance and the like, formation of the back face side resin film using the polyethylene terephthalate as a main polymer can enhance the cost reduction capability, heat resistance, thermal dimensional stability and the like of the back sheet for photovoltaic modules. In addition, since the polyethylene naphthalate is excellent in resistance to hydrolysis and heat resistance, the back face side resin film provided on the backmost face side (outdoor air side) using the polyethylene naphthalate as a main polymer enables improvement of durability of the photovoltaic modules, and extension of usable time period of the photovoltaic modules socially demanded can be promoted.

The voltage endurable film includes and the substrate film may include polyethylene terephthalate as a principal component. The polyethylene terephthalate is inexpensive, and has various functions such as excellent heat resistance, voltage endurance and the like. Accordingly, formation of the voltage endurable film using the polyethylene terephthalate as a main polymer can improve the voltage endurance of the back sheet for photovoltaic modules, and additionally, the cost reduction capability, heat resistance, thermal dimensional stability and the like can be enhanced. Moreover, formation of the substrate film of the barrier film using polyethylene terephthalate as a main polymer can enhance the cost reduction capability, heat resistance, thermal dimensional stability and the like of the back sheet for photovoltaic modules.

The voltage endurable film has a thickness of 50 µm or greater and 250 µm or less. The thickness of the voltage endurable film falling within the above range can impart high voltage endurance to the back sheet for photovoltaic modules, and can sufficiently and effectively meet with photovoltaic modules for photovoltaic systems with high system voltage which have been socially demanded these days.

Aluminum oxide or silica oxide may be used as the inorganic oxide that constitutes the inorganic oxide layer. By thus constructing the inorganic oxide layer using aluminum oxide or silica oxide, the gas barrier properties and cost reduction capability of the inorganic oxide layer can be enhanced.

A pigment may be dispersed in the front face side resin film. By thus including a pigment dispersed in the front face side resin film, the heat resistance, thermal dimensional stability, weather resistance, strength, age-related deterioration preventive properties and the like of the front face side resin film, in turn, of the back sheet for photovoltaic modules can be enhanced. Additionally, inclusion of a white pigment dispersed in the front face side resin film provided on the frontmost face side in the back sheet for photovoltaic modules adds a function of allowing the rays of light that is transmitted through the photovoltaic cell to be reflected to the photovoltaic cell side, whereby the power generation efficiency can be further improved.

Accordingly, the photovoltaic module including the light-transmissive substrate, the filler layer, the photovoltaic cell as a photovoltaic device, the filler layer, and the back sheet for photovoltaic modules laminated in this order can achieve significant improvement of the durability, weather resistance, operating life and the like, and reduction in production cost can be promoted, because the back sheet for photovoltaic modules has favorable various characteristics such as resistance to hydrolysis, gas barrier properties, weather resistance, cost reduction capability and the like, as described above. Furthermore, owing to strong adhesiveness between the back sheet for photovoltaic modules and the filler layer in the photovoltaic module, durability and operating life can be further increased. In addition, high voltage endurance imparted to the back sheet for photovoltaic modules in the photovoltaic module can increase the system voltage, thereby capable of facilitating reduction in loss of the power generation efficiency.

The term "front face side" herein means the light-receiving face side of the photovoltaic module, and of the back sheet for photovoltaic modules constructing the same. The term "back face side" means the front face side, i.e., the face opposite to the light-receiving side. The term "thickness of a film" means an average thickness of a film. The term "system voltage" means a voltage at the maximum output point under standard operating conditions in a photovoltaic system having a plurality of photovoltaic modules connected in series.

As explained in the foregoings, the back sheet for photovoltaic modules of the present invention is excellent in various characteristics such as weather resistance, gas barrier properties, heat resistance and the like and particularly in adhesiveness with the filler layer, resistance to hydrolysis and voltage endurance, and has favorable manufacturability and cost reduction capability. Additionally, the photovoltaic module in which the back sheet for photovoltaic modules is used has significantly improved durability, weather resistance, operating life and the like. Moreover, improvement of power generation efficiency is enabled by increase in the system voltage, and in addition, reduction in the production cost can be facilitated.

### BRIEF DESCRIPTION OF THE DRAWINGS

Fig. 1 shows a schematic cross-sectional view illustrating a back sheet for photovoltaic modules which do not belong to the present invention.
Fig. 2 shows a schematic cross-sectional view illustrating the back sheet for photovoltaic modules according to an embodiment of the present invention different from the back sheet for photovoltaic modules shown in Fig. 1.
Fig. 3 shows a schematic cross-sectional view illustrating the back sheet for photovoltaic modules according to an embodiment of the present invention different from the back sheets for photovoltaic modules shown in Fig. 1 and Fig. 2.
Fig. 4 shows a schematic cross-sectional view illustrating a photovoltaic module in which the back sheet for photovoltaic modules shown in Fig. 2 is used.
Fig. 5 shows a schematic cross-sectional view illustrating conventionally general photovoltaic modules.

### DESCRIPTION OF THE PREFERRED EMBODIMENTS

Hereinafter, embodiments of the present invention will be described in detail with appropriate references to the drawing.

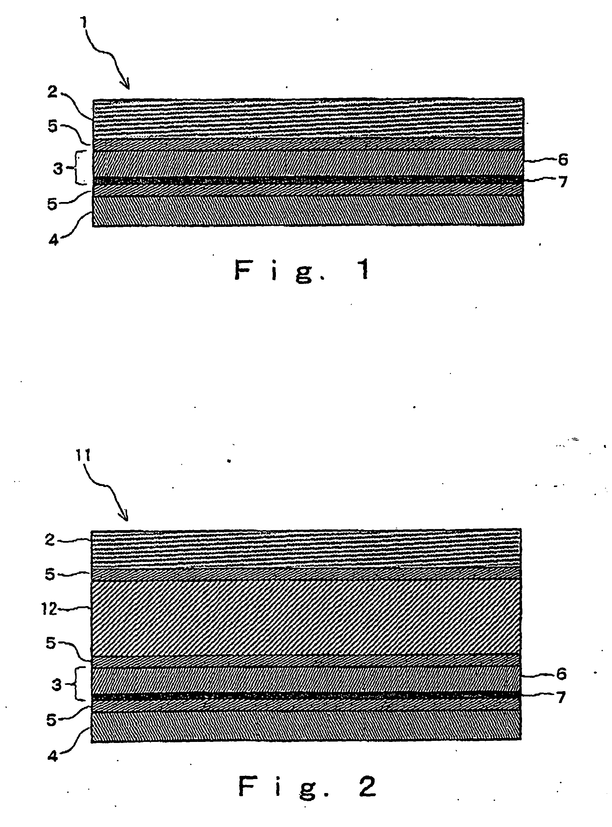

The back sheet 1 for photovoltaic modules shown in Fig. 1 is a laminate having a front face side resin film 2, a barrier film 3 and a back face side resin film 4 in this order from the front face side to the back face side, which are laminated via an adhesive layer 5. This embodiment is not within the scope of the invention, wherein details described belong to embodiments according to the invention.

The front face side resin film 2 is formed using a synthetic resin as a principal component. As the synthetic resin to be the principal component of the front face side resin film 2, polyolefin is used which has favorable resistance to hydrolysis, and adhesiveness to the ethylene-vinyl acetate copolymer (EVA) usually used in the filler layer of the photovoltaic module described later. Examples of this polyolefin include polyethylene (e.g., high density polyethylene, low density polyethylene and the like), copolymers of polypropylene, ethylene with an unsaturated carboxylate ester (e.g., ethylene-vinyl acetate copolymer, ethylene-methyl acrylate copolymer, ethylene-methyl methacrylate copolymer and the like), copolymers of ethylene and unsaturated carboxylic acid (e.g.; ethylene-acrylic acid copolymer, ethylene-methacrylic acid copolymer and the like), ionomer resins, and the like. Among these, polyethylene that exhibits favorable balance of costs and various functions such as adhesiveness to the filler layer, resistance to hydrolysis, heat resistance, weather resistance and the like, as well as cyclic polyolefin-based resins that are excellent in functional properties such as heat resistance, strength, weather resistance, durability and gas barrier properties in addition to the adhesiveness to the filler layer are preferred.

Examples of the cyclic polyolefin-based resin include c.g., a) polymers obtained by polymerization of cyclic diene such as cyclopentadiene (and a derivative thereof), dicyclopentadiene (and a derivative thereof), cyclohexadiene (and a derivative thereof), norbornadiene (and a derivative thereof) or the like, b) copolymers obtained by copolymerization of one, or two or more of the olefin-based monomers such as ethylene, propylene, 4-methyl-1-pentene, styrene, butadiene and isoprene with the cyclic diene, and the like. Among these cyclic polyolefin-based resins, polymers of cyclic diene such as cyclopentadiene (and a derivative thereof), dicyclopentadiene (and a derivative thereof) or norbornadiene (and a derivative thereof) that are excellent in the strength, heat resistance, weather resistance and the like are particularly preferred.

As the material for forming the front face side resin film 2, the aforementioned synthetic resin can be used alone, or as a mixture of two or more thereof. Also, a synthetic resin other than polyolefin can be also used in combination. Moreover, a variety of additives can be blended in the material for forming the front face side resin film 2 for the purpose of improving and/or modifying the processibility, heat resistance, weather resistance, mechanical properties, dimension accuracy and the like. Examples of the additive include e.g., lubricants, crosslinking agents, antioxidants, ultraviolet ray-absorbing agents, Light stabilizers, fillers, reinforcing fibers, strengthening agents, antistatic agents, fire retardants, flame retardants, foaming agents, fungicides, pigment, and the like. The method of molding the front face side resin film 2 is not particularly limited, but for example, a known method such as an extrusion method, a cast molding method, a T-die method, a cut ting method, an inflation method or the like may be employed. The front face side resin film 2 may have either a monolayer structure, or a multilayer structure including two or more layers.

The lower limit of the thickness of the front face side resin film 2 is preferably 25 µm, and particularly preferably 50 µm. In contrast, the upper limit of the thickness of the front face side resin film 2 is preferably 125 µm, and particularly preferably 100 µm. The front face side resin film 2 having a thickness less than the aforementioned lower limit is disadvantageous in that handling in lamination of the back sheet 1 for photovoltaic modules may be difficult, and that the color and functional properties of the front face side resin film 2 attained by the included pigment described later may be insufficient, and the like. To the contrary, when the front face side resin film 2 has a thickness exceeding the upper limit, demands for reduction in thickness and weight saving of the photovoltaic module may not be satisfied.

The front face side resin film 2 may include a pigment dispersed therein. By thus including a pigment dispersed in the front face side resin film 2, various characteristics such as heat resistance, weather resistance, durability, thermal dimensional stability, strength and the like of the front face side resin film 2, in turn, of the back sheet 1 for photovoltaic modules can be improved. Further, by including a white pigment dispersed in the front face side resin film 2, a function of allowing the rays of light transmitted the photovoltaic cell to be reflected is added, whereby the power generation efficiency can be further improved. Moreover, design of the photovoltaic module can be improved by including a black pigment dispersed in the front face side resin film 2 to provide a variously colored front face side resin film 2.

The white pigment is not particularly limited, but for example, calcium carbonate, titanium oxide, zinc oxide, lead carbonate, barium sulfate or the like can be used. Among them, calcium carbonate is preferred which is excellent in dispersibility in the resin material that forms the synthetic resin layer, and which exhibits a comparatively great effect of improving the durability, heat resistance, strength and the like of the synthetic resin layer. The calcium carbonate can have a crystal form such as calcite, aragonite, vaterite and the like, and any crystal form is acceptable for use. This calcium carbonate may be subjected to a surface finishing treatment with stearic acid, sodium dodecylbenzenesulfonate, a silane coupling agent, a titanium coupling agent or the like, and impurities such as magnesium oxide, aluminum oxide, silicon dioxide, titanium dioxide and the like may be also included in an amount of approximately 10% or less. Examples of the other pigment include black pigments such as carbon black, blue pigments such as ultramarine and prussian blue, red pigments such as blood red (iron oxide red), cadmium red and molybdenum orange, metal powder pigments that impart metallic luster, and the like, which can be responsible for improvement of the photovoltaic module design.

The average particle size of the pigment is preferably 100 nm or greater and 30 µm or less, and particularly preferably 300 nm or greater and 3 µm or less. When the average particle size of the pigment is below the above range, uniform dispersion in the film may be difficult due to the aggregation or the like. In contrast, when the average particle size of the pigment exceeds the above range, the effect of improving various characteristics such as heat resistance for the front face side resin film 2 may be decreased.

The content of the pigment is preferably 8% by weight or greater and 30% by weight or less. When the content of the pigment is smaller than the aforementioned lower limit, the effect of improving the durability, heat resistance, strength and the like of the front face side resin film 2 may be decreased. In contrast, when the content of the pigment is greater than the aforementioned upper limit, dispersibility of the pigment in the film may be deteriorated, whereby reduction in strength of the front face side resin film 2 may be caused.

The barrier film 3 has a substrate film 6, and an inorganic oxide layer 7 laminated on the back face of this substrate film 6.

The substrate film 6 is formed using a synthetic resin as a principal component. The synthetic resin used as the principal component of this substrate film 6 is not particularly limited, and examples thereof include e.g., polyethylene-based resins, polypropylene-based resins, cyclic polyolefin-based resins, polystyrene-based resins, acrylonitrile-styrene copolymers (AS resins, acrylonitrile-butadiene-styrene copolymers (ABS resins), polyvinyl chloride-based resins, fluorine-based resins, poly(meth)acrylic resins, polycarbonate-based resins, polyester-based resins, polyamide-based resins, polyimide-based resins, polyamideimide-based resins, polyaryl phthalate-based resins, silicone-based resins, polysulfone-based resins, polyphenylenesulfide-based resins, polyethersulfone-based resins, polyurethane-based resins, acetal-based resins, cellulose-based resins, and the like. Among the above-listed resins, polyester-based resins, fluorine-based resins and cyclic polyolefin-based resins having great heat resistance, strength, weather resistance, durability, gas barrier properties against water vapor or the like, and the like are preferred.

Examples of the polyester-based resin include e.g., polyethylene terephthalate, polyethylene naphthalate, and the like. Among these polyester-based resins, polyethylene terephthalate that exhibits favorable balance of costs and various functions such as heat resistance, weather resistance and the like is particularly preferred.

Examples of the fluorine-based resin include e.g., polytetrafluoroethylene (PTFE), perfluoroalkoxy resins (PFA) consisting of a copolymer of tetrafluoroethylene and perfluoroalkylvinyl ether, copolymers (FEP) of tetrafluoroethylene and hexafluoropropylene, copolymers (EPE) of tetrafluoroethylene, perfluoroalkylvinyl ether and hexafluoropropylene, copolymers (ETFE) of tetrafluoroethylene and ethylene or propylene, polychlorotrifluoroethylene resins (PCTFE), copolymers (ECTFE) of ethylene and chlorotrifluoroethylene, vinyl fluorideidene-based resins (PVDF), vinyl fluoride-based resins (PVF), and the like. Among these fluorine-based resins, polyvinyl fluoride-based resins (PVF), and the copolymers (ETFE) of tetrafluoroethylene and ethylene or propylene that are excellent in the strength, heat resistance, weather resistance and the like are particularly preferred.

As the material for forming the substrate film 6, the aforementioned synthetic resin can be used alone, or two or more can be used as a mixture. The method of molding the substrate film 6, and additives which may be included in the material for forming the substrate film 6 may be selected in a similar manner to those in the front face side resin film 2 described above.

The lower limit of the thickness of the substrate film 6 is 7 µm, and particularly preferably 10 µm. In contrast, the upper limit of the thickness of the substrate film 6 is 20 µm, and particularly preferably 15 µm. When the thickness of the substrate film 6 is less than the aforementioned lower limit, disadvantages are caused, e.g., curling is likely to occur in vapor deposition processing for forming the inorganic oxide layer 7, and the handling may be difficult. To the contrary, when the thickness of the substrate film 6 is greater than the aforementioned upper limit, demands for reduction in thickness and weight saving of the photovoltaic module may not be satisfied.

The inorganic oxide layer 7 is provided for the purpose of imparting gas barrier properties against oxygen, water vapor and the like, and is formed by vapor deposition of an inorganic oxide on the back face of the substrate film 6. The means for the vapor deposition for forming the inorganic oxide layer 7 is not particularly limited as long as vapor deposition of the inorganic oxide is executed without causing deterioration of the synthetic resin substrate film 6 such as contraction, yellowing and the like. Examples of the applicable means include (a) physical vapor deposition (PVD) such as vacuum evaporation, sputtering, ion plating, ion cluster beam methods and the like, and (b) chemical vapor deposition (CVD) such as plasma chemical vapor deposition, thermal chemical vapor deposition, photochemical vapor deposition and the like. Among these vapor deposition, vacuum evaporation and ion plating are preferred which enable formation of the inorganic oxide layer 7 having high quality with high productivity.

The inorganic oxide that constitutes the inorganic oxide layer 7 is not particularly limited as long as it has gas barrier properties, and for example, aluminum oxide, silica oxide, titanium oxide, zirconium oxide, zinc oxide, tin oxide, magnesium oxide or the like may be used. Of these, aluminum oxide or silica oxide is particularly preferred because of favorable balance of costs and gas barrier properties.

The lower limit of the thickness (average thickness) of the inorganic oxide layer 7 is 3 Å, and particularly preferably 400 Å. In contrast, the upper limit of the thickness of the inorganic oxide layer 7 is 3000 Å, and particularly preferably 800 Å. When the thickness of the inorganic oxide layer 7 is less than the aforementioned lower limit, gas barrier properties are likely to be deteriorated. To the contrary, when the thickness of the inorganic oxide layer 7 is greater than the aforementioned upper limit, less flexibility of the inorganic oxide layer 7 is achieved, whereby defects such as cracking are likely to occur.

The inorganic oxide layer 7 may have either a monolayer structure, or a multilayer structure including two or more layers. By the formation of the inorganic oxide layer 7 having a multilayer structure, deterioration of the substrate film 6 can be minimized through reduction of thermal burden applied during the vapor deposition, and further, adhesion properties between the substrate film 6 and the inorganic oxide layer 7 can be improved. In addition, conditions of the vapor deposition employed in the aforementioned physical vapor deposition and chemical vapor deposition may be arbitrarily determined depending on the resin type of the substrate film 6, thickness of the inorganic oxide layer 7, and the like.

Moreover, for improving the coherent adhesiveness and the like between the substrate film 6 and the inorganic oxide layer 7, the vapor deposited face of the substrate film 6 may be subjected to a surface finishing treatment. Examples of such a surface finishing treatment for improving the adhesion properties include e.g., (a) a corona discharge treatment, an ozone treatment, low-temperature plasma treatment using an oxygen gas, a nitrogen gas or the like, a glow discharge treatment, oxidizing treatments using a chemical or the like, (b) a primer coating treatment, an undercoating treatment, an anchor coating treatment, a vapor deposition anchor coating treatment, and the like. Among these surface finishing treatments, the corona discharge treatment and the anchor coating treatment are preferred which achieve enhancement of the adhesive strength to the inorganic oxide layer 7, and are responsible for formation of compact and uniform inorganic oxide layer 7.

Examples of the anchor coating agent which may be used in the aforementioned anchor coating treatment include e.g., polyester-based anchor coating agents, polyamide-based anchor coating agents, polyurethane-based anchor coating agents, epoxy-based anchor coating agents, phenol-based anchor coating agents, (meth)acrylic anchor coating agents, polyvinyl acetate-based anchor coating agents, polyolefin--based anchor coating agents such as those including polyethylene or polypropylene as the base, cellulose-based anchor coating agents, and the like. Among these anchor coating agents, polyester-based anchor coating agents which can further enhance the adhesive strength between the substrate film 6 and the inorganic oxide layer 7 are particularly preferred.

The lower limit of the amount of coating of the aforementioned anchor coating agent (calculated based on the solid content) is preferably 0.1 g/m², and particularly preferably 1 g/m². In contrast, the upper limit of the amount of coating of the anchor coating agent is preferably 5 g/m², and particularly preferably 3 g/m². When the amount of coating of the anchor coating agent is less than the aforementioned lower limit, the effect of improving the adhesion properties between the substrate film 6 and the inorganic oxide layer 7 may be decreased. To the contrary, when the amount of coating of the anchor coating agent is greater than the aforementioned upper limit, strength, durability and the like of the back sheet 1 for photovoltaic modules may be deteriorated.

In the anchor coating agent described above, can be blended a variety of additives such as a silane coupling agent for improving coherent adhesiveness, an antiblocking agent for preventing blocking with the substrate film 6, an ultraviolet ray-absorbing agent for improving weather resistance, and the like. The amount of the blending such additives is preferably 0.1% by weight or more and 10% by weight or less in light of the balance of the effect exhibited by the additive, and possible inhibition of the function to be performed by the anchor coating agent.

The back face side resin film 4 is formed using a synthetic resin as a principal component. The synthetic resin which may be used as the principal component of this back face side resin film 4 is similar to those of the substrate film 6 of the barrier film 3 described above. However, polyethylene terephthalate that exhibits favorable balance of costs and various functions such as heat resistance, weather resistance and the like, and polyethylene naphthalate (PEN) that is excellent in the resistance to hydrolysis and heat resistance are preferred. In addition, the molding method of the back face side resin film 4, the additives to be included in the material for forming the back face side resin film 4, and the like may be arbitrarily determined similarly to the front face side resin film 2.

The polyethylene naphthalate is a polyester resin including ethylene naphthalate as a main recurring unit, and is synthesized with naphthalenedicarboxylic acid as a main dicarboxylic acid component, and with ethylene glycol as a main glycol component.

This ethylene naphthalate unit is preferably included at 80% by mole or more of the entire recurring units of the polyester. When the percentage of the ethylene naphthalate unit is less than 80% by mole, resistance to hydrolysis, strength, barrier propertied to be achieved by the polyethylene naphthalate may be deteriorated.

Examples of the naphthalenedicarboxylic acid include
2,6-naphthalenedicarboxylic acid,
1,4-naphthalenedicarboxylic acid,
1,5-naphthalenedicarboxylic acid,
1,3-naphthalenedicarboxylic acid and the like. In light of the aforementioned resistance to hydrolysis and the like,
2,6-naphthalenedicarboxylic acid is particularly preferred.

A carbodiimide compound may be included in the polyethylene naphthalate. By thus including a carbodiimide compound, the resistance to hydrolysis of the back face side resin film 4 is markedly improved. The content of this carbodiimide compound is preferably 0.1% by weight or greater and 10% by weight or less, and particularly preferably 0.5% by weight or greater and 3% by weight or less. The content of the carbodiimide compound falling within the above range can effectively improve the resistance to hydrolysis of the back face side resin film 4.

Examples of the carbodiimide compound include e.g., (a) monocarbodiimide such as N,N'-diphenylcarbodiimide, N,N'-diisopropylphenylcarbodiimide, N,N'-dicyclohexylcarbodiimide, 1,3-diisopropylcarbodiimide, 1- (3-dimethylamino propyl) -3-ethylcarbodiimide and the like, and (b) polycarbodiimide compounds such as poly (1,3,5-triisopropylphenylene-2,4-carbodiimide) and the like. Among these, N,N'-diphenylcarbodiimide and N,N'-diisopropylphenylcarbodiimide are preferred, which can improve the resistance to hydrolysis of the back face side resin film 4 to a greater extent. In addition, the molecular weight of the carbodiimide compound is preferably in the range of from 200 to 1000, and particularly preferably in the range of from 200 to 600. When the molecular weight exceeds the aforementioned upper limit, dispersibility of the carbodiimide compound in the resin is deteriorated, whereas dustability of the carbodiimide compound may be increased when the molecular weight is below the aforementioned lower limit.

Further, in addition to the aforementioned carbodiimide compound, an antioxidant may be included in the aforementioned polyethylene naphthalate. By thus including an antioxidant along with the carbodiimide compound in the polyethylene naphthalate, the resistance to hydrolysis described above is markedly improved, and further, degradation of the carbodiimide compound can be also suppressed. The content of this antioxidant is preferably 0.05% by weight or greater and 1% by weight or less, and particularly preferably 0.1% by weight or greater and 0.5% by weight or less. When the content of the antioxidant is less than the aforementioned lower limit, the performance to suppress the degradation of carbodiimide, and the effect of improving the resistance to hydrolysis may be deteriorated. When the content of the antioxidant is greater than the aforementioned upper limit, color tone of the back face side resin film 4 may be impaired. Specifically, hindered phenol-based compounds and thioether-based compounds are preferred as the antioxidant, and the hindered phenol-based compounds are particularly preferred, which can effectively improve the resistance to hydrolysis of the back face side resin film 4. The weight ratio of the antioxidant content to the carbodiimide compound content is preferably 0.1 or greater and 1.0 or less, and particularly preferably 0.15 or greater and 0.8 or less. When this weight ratio is less than the aforementioned lower limit, the effect of suppressing the hydrolysis of the carbodiimide itself may be insufficient. To the contrary, when the weight ratio is greater than the aforementioned upper limit, the effect of suppressing the hydrolysis of the carbodiimide may reach to the plateau. The method of adding the carbodiimide compound and the antioxidant may be either a method of kneading in polyethylene naphthalate, or a method of adding to a polycondensation reaction of the polyethylene naphthalate.

The amount of the terminal carboxyl group of polyethylene naphthalate is preferably 10 eq/T (equivalence/10⁶ g) or greater and 40 eq/T or less, particularly preferably 10 eq/T or greater and 30 eq/T or less, and still more preferably 10 eq/T or greater and 25 eq/T. When the amount of the terminal carboxyl group is higher than the aforementioned upper limit, the effect of improving the resistance to hydrolysis achieved by the carbodiimide compound may be decreased. When the amount of the terminal carboxyl group is lower than the aforementioned lower limit, productivity may be deteriorated.

Additionally, an aromatic polyester may be included in the polyethylene naphthalate. By thus including the aromatic polyester in the polyethylene naphthalate, knot strength, resistance to delamination, mechanical strength and the like can be enhanced while maintaining the resistance to hydrolysis of the back face side resin film 4. The content of this aromatic polyester is preferably 1% by weight or greater and 10% by weight or less. By including the aromatic polyester at a content falling within the above range, the knot strength, resistance to delamination, mechanical strength and the like can be effectively enhanced. As the aromatic polyester, specifically, polyesters prepared by copolymerization using a terephthalic acid component and 4,4'-diphenyldicarboxylic acid as a main dicarboxylic acid component, and ethylene glycol as a main glycol component are preferred.

The method of production of the polyethylene naphthalate is not particularly limited, and any of a variety of known methods such as an ester exchange method, a direct esterification method or the like can be employed. Furthermore, the molding method of the back face side resin film 4 the additives additives to be included in the material for forming the back face side resin film 4, and the like may be arbitrarily determined similarly to the front face side resin film 2.

The lower limit of the thickness of the back face side resin film 4 is preferably 12 µm, and particularly preferably 25 µm. In contrast, the upper limit of the thickness of the back face side resin film 4 is preferably 250 µm, and particularly preferably 188 µm. When the thickness of the back face side resin film 4 is less than the aforementioned lower limit, basic performances of the back sheet 1 for photovoltaic modules such as strength, weather resistance, heat resistance and the like as well as the corresponding system voltage may be decreased, and disadvantages such as difficulty in handling of the back face side resin film 4 may be also caused. To the contrary, when the thickness of the back face side resin film 4 is greater than the aforementioned upper limit, demands for reduction in thickness and weight saving of the photovoltaic module may not be satisfied. When the back face side resin film 4 includes polyethylene naphthalate as a principal component, ensuring the basic performances such as weather resistance and the like, and the corresponding system voltage by having the thickness of the back face side resin film 4 being 12 µm or greater and 50 µm or less, and laminating the voltage endurable film 12 described later is more preferred in light of the economical efficiency.

The adhesive layer 5 is laminated between each film of the superposed front face side resin film 2, barrier film 3 and back face side resin film 4. Owing to this adhesive layer 5, the above each film is fixed by adhesion, leading to improvement of the strength, durability, toughness of the back sheet 1 for photovoltaic modules and the like. Further, sealing and protecting functions are performed to compensate for defects of the inorganic oxide layer 7.

As the adhesive that constitutes the adhesive layer 5, an adhesive for lamination or a melt-extruded resin is used. Examples of the adhesive for lamination include e.g., adhesives for dry lamination, adhesives for wet lamination, adhesives for hot melt lamination, adhesives for nonsolvent lamination, and the like. Among these adhesives for lamination, adhesives for dry lamination are particularly preferred which are excellent in the adhesive strength, durability, weather resistance and the like, and have the sealing and protecting functions to compensate for defects (for example, scratch, pinhole, recessed part and the like) of the surface of the inorganic oxide layer 7.

Examples of the adhesive for dry lamination include e.g., polyvinyl acetate-based adhesives, polyacrylic ester-based adhesives consisting of a homopolymer of an ethyl, butyl, 2-ethylhexyl ester or the like of acrylic acid, or a copolymer of the homopolymer and methyl methacrylate, acrylonitrile, styrene or the like, cyano acrylate-based adhesives, ethylene copolymer-based adhesives consisting of a copolymer of ethylene and a monomer such as vinyl acetate, ethyl acrylate, acrylic acid, methacrylic acid or the like, cellulose-based adhesives, polyester-based adhesives, polyamide-based adhesives, polyimide-based adhesives, amino resin-based adhesives consisting of an urea resin, a melamine resin or the like, phenol resin-based adhesives, epoxy-based adhesives, polyurethane-based adhesives, reactive (meth)acrylic adhesives, rubber-based adhesives consisting of a chloroprene rubber, a nitrile rubber, a styrene-butadiene rubber or the like, silicone-based adhesives, inorganic adhesives consisting of alkali metal silicate, low-melting point glass or the like. Among these adhesives for dry lamination, polyurethane-based adhesives, particularly polyester urethane-based adhesives are preferred which prevent the back sheet 1 for photovoltaic modules from decrease in the adhesive strength and from delamination caused by the long-term use out of doors, and which suppress deterioration such as yellowing and the like of the adhesive layer 5. Meanwhile, aliphatic polyisocyanate accompanied by less thermal yellowing is preferred as a curing agent.

As the melt extruded resin one or two or more thermoplastic resin(s) such as, for example, polyethylene-based resins, polypropylene-based resins, acid modified polyethylene-based resins, acid modified polypropylene-based resins, ethylene-acrylic acid or methacrylic acid copolymers, SURLYN-based resins, ethylene-vinyl acetate copolymers, polyvinyl acetate-based resins, ethylene-acrylic ester or methacrylic ester copolymers, polystyrene-based resins, polyvinyl chloride-based resins and the like can be used. When the extrusion lamination method is employed in which the melt extruded resin is used, it is desired that the opposing face to the lamination of each film described above is subjected to the aforementioned surface finishing treatment such as anchor coating treatment or the like for achieving more rigid adhesion strength.

The lower limit of the amount of lamination (calculated based on the solid content) of the adhesive layer 5 is preferably 1 g/m², and particularly preferably 3 g/m². In contrast, the upper limit of the amount of lamination of the adhesive layer 5 is preferably 10 g/m², and particularly preferably 7 g/m². When the amount of lamination of the adhesive layer 5 is smaller than the aforementioned lower limit, adhesion strength and the sealing function to compensate for the defects of the inorganic oxide layer 7 may not be attained. To the contrary, when the amount of lamination of the adhesive layer 5 is greater than the aforementioned upper limit, strength and durability of the laminated layer may be deteriorated.

In the adhesive for lamination or the melt extruded resin for forming the adhesive layer 5 may be blended a variety of additives ad libitum such as e.g., a solvent, a lubricant, a crosslinking agent, an antioxidant, an ultraviolet ray-absorbing agent, a light stabilizer, a filler, a reinforcing fiber, a strengthening agent, an antistatic agent, a fire retardant, a flame retardant, a foaming agent, an fungicide, a pigment and the like for the purpose of improving and modifying the handleability, heat resistance, weather resistance, mechanical properties and the like.

The manufacturing steps of the back sheet 1 for photovoltaic modules generally include (1) a step of producing the barrier film by vapor deposition of an inorganic oxide on the back face of the substrate film 6 with the aforementioned PVD or CVD method, and (2) a lamination step of coating an adhesive on one of the opposing face to the lamination of the front face side resin film 2, the barrier film 3 and the back face side resin film 4 by means such as roll coating, gravure roll coating, kiss coating or the like, and pasting other opposing face to the lamination to this coating face.

Because the back sheet 1 for photovoltaic modules has high gas barrier properties owing to including the barrier film 3 in which the inorganic oxide layer 7 is laminated on the back face of the substrate film 6, whereby mechanical strength, cost reduction capability, productivity and voltage endurance can be promoted as compared with conventional back sheets for photovoltaic modules in which a metal foil is used. In addition, since the back sheet 1 for photovoltaic modules uses polyolefin as a material for forming the front face side resin film 2, it is excellent in adhesiveness with the ethylene-vinyl acetate copolymer (EVA) generally used in the filler layer of the photovoltaic modules, and has favorable resistance to hydrolysis. Therefore, the back sheet 1 for photovoltaic modules can improve durability of the photovoltaic modules, and can promote extension of usable time period of the photovoltaic modules socially demanded. Further, when polyethylene naphthalate that is excellent in the resistance to hydrolysis and heat resistance is used as a material for forming the back face side resin film 4 provided on the backmost face side (outdoor air side) in the back sheet 1 for photovoltaic modules, durability of the photovoltaic modules can be improved, and extension of usable time period of the photovoltaic modules socially demanded can be further promoted.

The back sheet 11 for photovoltaic modules shown in Fig. 2 is a laminate having a front face side resin film 2, a voltage endurable film 12, a barrier film 3 and a back face side resin film 4 in this order from the front face side to the back face side, which are laminated via an adhesive layer 5.

The front face side resin film 2, the barrier film 3, the back face side resin film 4 and the adhesive layer 5 of the back sheet 11 for photovoltaic modules are similar to those in the aforementioned back sheet 1 for photovoltaic modules shown in Fig. 1, therefore, explanation of them will be omitted through designating the identical numbers.

The voltage endurable film 12 is formed using a synthetic resin in form of a polyethylene terephthalate as a principal component. As the synthetic resin in form of a polyethylene terephthalate to be the principal component of the voltage endurable film 12, similar one to that of the substrate film 6 of the barrier film 3 may be used. Polyethylene terephthalate exhibits favorable balance of costs and various functions such as heat resistance, weather resistance and the like is particularly preferred. Also, the molding method of the voltage endurable film 12, and the additives to be included in the material for forming the voltage endurable film 12 are similar to those for the front face side resin film 2 as described above.

The thickness of the voltage endurable film 12 may be determined ad libitum depending on the voltage endurance required for the back sheet 11 for photovoltaic modules. Specific lower limit of the thickness of the voltage endurable film 12 is 50 µm, and particularly preferably 100 µm. In contrast, the upper limit of the thickness of the voltage endurable film 12 is 250 µm, and particularly preferably 200 µm. When the thickness of the voltage endurable film 12 is less than the aforementioned lower limit, the voltage endurance of the back sheet 1 for photovoltaic modules may not be elevated enough. To the contrary, when the thickness of the voltage endurable film 12 is greater than the aforementioned upper limit, demands for reduction in thickness and weight saving of the photovoltaic module may not be satisfied.

Since the back sheet 11 for photovoltaic modules has the front face side resin film 2 including polyethylene, the barrier film 3 and the back face side resin film 4, similarly to the back sheet 1 for photovoltaic modules, it is excellent in various characteristics such as weather resistance, durability, heat resistance, gas barrier properties and the like and is particularly excellent in the adhesiveness to the filler layer, resistance to hydrolysis and voltage endurance, and it is accompanied by favorable manufacturability and cost reduction capability. In addition, since the back sheet 11 for photovoltaic modules has a voltage endurable film 12 laminated between the front face side resin film 2 and the barrier film 3, it has high voltage endurance, enabling application to photovoltaic modules for photovoltaic systems with high system voltage. Additionally, the voltage endurance of the back sheet 11 for photovoltaic modules can be adjusted by regulating the thickness of the voltage endurable film 12, thereby enabling matching to the system voltage of the photovoltaic system with which it is equipped.

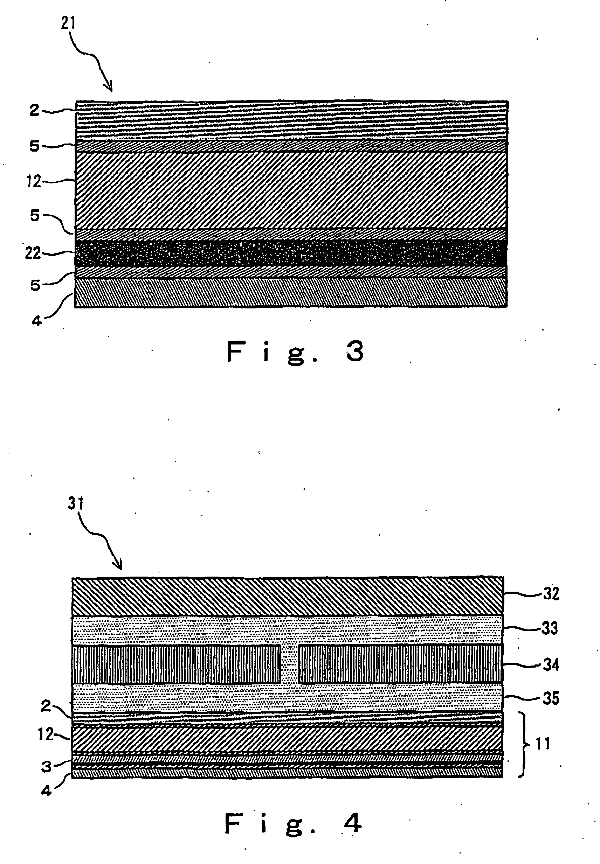

The back sheet 21 for photovoltaic modules shown in Fig. 3 is a laminate having a front face side resin film 2, a voltage endurable film 12, a barrier film 22 and a back face side resin film 4 in this order from the front face side to the back face side, which are laminated via an adhesive layer 5.

The front face side resin film 2, the back face side resin film 4 and the adhesive layer 5 of the back sheet 21 for photovoltaic modules are similar to those in the aforementioned back sheet 1 for photovoltaic modules shown in Fig. 1, and the voltage endurable film 12 is similar to that in the back sheet 11 for photovoltaic modules shown in Fig. 2, therefore, explanation of them will be omitted through designating the identical numbers.

As the barrier film 22, an aluminum foil is used. Exemplary material of the aluminum foil includes aluminum or an aluminum alloy, and an aluminum-iron alloy (soft material) is preferred. The iron content of the aluminum-iron alloy is preferably 0.3% or greater and 9.0% or less, and particularly preferably 0.7% or greater and 2.0% or less. When the iron content is less than the aforementioned lower limit, the effect of preventing generation of the pinhole may be insufficient. To the contrary, when the iron content is greater then the aforementioned upper limit, flexibility may be reduced, which may lead to reduction in the processibility. Additionally, the material of the aluminum foil is preferably soft aluminum subjected to an annealing treatment in light of preventing generation of wrinkles and pinholes.

The lower limit of the thickness (average thickness) of the aluminum foil is 6 µm, and particularly preferably 15 µm. In contrast, the upper limit of the thickness of the aluminum foil is 30 µm, and particularly preferably 20 um. When the thickness of the aluminum foil is less than the aforementioned lower limit, breakage of the aluminum foil is likely to occur in the processing, and the gas barrier properties may be deteriorated resulting from the pinhole. To the contrary, when the thickness of the aluminum foil is greater than the aforementioned upper limit, cracking or the like may be caused during the processing, and the increase in the thickness and the weight of the back sheet 21 for photovoltaic modules may result in failure in satisfying the social demands for the thin and light modeling.

The surface of the aluminum foil may be subjected to a surface finishing treatment such as e.g., a chromate treatment, a phosphate treatment, a lubricating property resin coating treatment or the like in light of preventing dissolution and corrosion. Also, in light of promoting the adhesiveness it may be subjected to a coupling treatment or the like.

Since the back sheet 21 for photovoltaic modules has the front face side resin film 2 including polyethylene, the voltage endurable film 12, the barrier film 22 and the back face side resin film 4, similarly to the back sheet 11 for photovoltaic modules, it is excellent in various characteristics such as weather resistance, durability, heat resistance, gas barrier properties and the like and is particularly excellent in the adhesiveness to the filler layer, resistance to hydrolysis and voltage endurance, and it is accompanied by favorable manufacturability and cost reduction capability. In addition, since the back sheet 21 for photovoltaic modules has an aluminum foil used as the barrier film 22, high gas barrier properties against oxygen, water vapor and the like are exhibited, thereby capable of promoting extension of operating life and usable time period of the photovoltaic module.

The photovoltaic module 31 shown in Fig. 4 has a light-transmissive substrate (i.e., transparent substrate, translucent substrate or the like) 32, a filler layer 33, a plurality of photovoltaic cells 34, a filler layer 35, and the back sheet 11 for photovoltaic modules laminated in this order from the front face side.

The light-transmissive substrate 32 is to be laminated on the frontmost face, and requires: a) to have transmittivity of sunlight, and electrical insulation properties b) to be excellent in mechanical, chemical and physical strength, specifically, in weather resistance, heat resistance, durability, water resistance, gas barrier properties against water vapor and the like, wind blast resistance, chemical resistance, and toughness; and c) to have high surface hardness, and to be excellent in antifouling properties to prevent the surface from fouling, accumulation of dirts and the like.

As the material for forming the light-transmissive substrate 32, glass or a synthetic resin may be used. Examples of the synthetic resin used in the light-transmissive substrate 32 include e.g., polyethylene-based resins, polypropylene-based resins, cyclic polyolefin-based resins, fluorine-based resins, polystyrene-based resins, acrylonitrile-styrene copolymers (AS resins, acrylonitrile-butadiene-styrene copolymers (ABS resins), polyvinyl chloride-based resins, fluorine-based resins, poly(meth)acrylic resins, polycarbonate-based resins, polyester-based resins such as polyethylene terephthalate and polyethylene naphthalate, polyamide-based resins such as a variety of nylon, polyimide-based resins, polyamideimide-based resins, polyaryl phthalate-based resins, silicone-based resins, polyphenylenesulfide-based resins, polysulfone-based resins, acetal-based resins, polyethersulfone-based resins, polyurethane-bascd resins, cellulose-based resins, and the like. Among these resins, fluorine-based resins, cyclic polyolefin-based resins, polycarbonate-based resins, poly (meth)acrylic resins or polyester-based resins are particularly preferred.

In the case of the light-transmissive substrate 32 made of a synthetic resin, (a) lamination of a transparent vapor deposition film of an inorganic oxide such as silicon oxide, aluminum oxide or the like on one face thereof by the PVD or CVD method as described above for the purpose of improving the gas barrier properties and the like; and (b) blending a variety of additives such as e.g., a lubricant, a crosslinking agent, an antioxidant, an ultraviolet ray-absorbing agent, an antistatic agent, a light stabilizer, a filler, a reinforcing fiber, a strengthening agent, a fire retardant, a flame retardant, a foaming agent, an fungicide, a pigment and the like for the purpose of improving and modifying the processibility, heat resistance, weather resistance, mechanical properties, dimension accuracy and the like are also acceptable.

The thickness (average thickness) of the light-transmissive substrate 32 is not particularly limited, and may be determined ad libitum such that necessary strength, gas barrier properties and the like are provided depending on the material used. The thickness of the light-transmissive substrate 32 made of the synthetic resin is preferably 6 µm or greater and 300 µm or less, and particularly preferably 9 µm or greater and 150 µm or less. Moreover, the thickness of the light-transmissive substrate 32 made of glass is generally about 3 mm.

The filler layer 33 and the filler layer 35 are filled around the photovoltaic cell 34 between the light-transmissive substrate 32 and the back sheet 11 for photovoltaic modules, and has (a) adhesiveness between the light-transmissive substrate 32 and the back sheet 11 for photovoltaic modules; and scratch resistance, shock absorbing properties and the like for protecting the photovoltaic cell 34. The filler layer 33 laminated on the surface of the photovoltaic cell 34 has transparency that permits transmission of the sunlight, in addition to the various functions as described above.

Examples of the material for forming the filler layer 33 and the filler layer 35 include e.g., fluorine-based resins, ethylene-vinyl acetate copolymer, ionomer resins, ethylene-acrylic acid or methacrylic acid copolymers, acid-modified polyolefin-based resins prepared by modification of a polyolefin-based resin such as a polyethylene resin, a polypropylene resin or polyethylene with an unsaturated carboxylic acid such as acrylic acid, polyvinylbutyral resins, silicone-based resins, epoxy-based resins, (meth)acrylic resins and the like. Among these synthetic resins, fluorine-based resins, silicone-based resins or cthylene-vinyl acetate-based resins that are excellent in the weather resistance, heat resistance, gas barrier properties and the like are preferred.

Moreover, the material which can be used for forming the filler layer 33 and the filler layer 35 includes heat reversible crosslinkable olefin-based polymer compositions described in Japanese Unexamined Patent Application Publication No. 2000-34376. More specifically the composition includes (a) a modified olefin-based polymer prepared by modification with unsaturated carboxylic anhydride and unsaturated carboxylate ester, with the average biding number of the carboxylic anhydride group per molecule being one or more, and with the ratio of the number of the carboxylate ester group to the number of the carboxylic anhydride group in the modified olefin-based polymer being 0.5 to 20, and (b) a hydroxyl group-containing polymer having an average binding number of the hydroxyl group per molecule being one or more, in which the ratio of the number of the hydroxyl group in the component (b) to the number of the carboxylic anhydride group in the component (a) is 0.1 to 5, and the like.

In the material for forming the filler layer 33 and the filler layer 35 may be blended a variety of additives ad libitum such as e.g., a crosslinking agent, a thermal antioxidant, a light stabilizer, an ultraviolet ray-absorbing agent, a photooxidation inhibitor and the like for the purpose of improving weather resistance, heat resistance, gas barrier properties and the like. Moreover, the thickness (average thickness) of the filler layer 33 and the filler layer 35 is not particularly limited, but is preferably 200 µm or greater and 1000 µm or less, and particularly preferably 350 µm or greater and 600 µm or less.

The aforementioned photovoltaic cell 34 is a photovoltaic device that converts light energy into electrical energy, and is provided between the filler layer 33 and the filler layer 35. A plurality of the photovoltaic cells 34 are laid on a substantially identical plane, which are wired in series or in parallel although not shown in the Figure. As the photovoltaic cell 34, for example, crystalline silicon photovoltaic elements such as single crystalline silicon type photovoltaic elements, polycrystalline silicon type photovoltaic elements and the like, amorphous silicon photovoltaic elements of single joint type, tandem structure type and the like, semiconductor photovoltaic elements with compounds of groups 3 to 5 such as gallium arsenic (GaAs), indium phosphorus (InP) and the like, compound semiconductor photovoltaic elements with compounds of groups 2 to 6 such as cadmium tellurium (CdTe), copper indium selenide (CuInSe2) and the like can be used, and the hybrid element of the same can be also used. The filler layer 33 or the filler layer 35 is also filled between a plurality of the photovoltaic cells 34 without any gap.

The method for production of the photovoltaic module 31 is not particularly limited, but in general, includes (1) a step of superposing the light-transmissive substrate 32, the filler layer 33, a plurality of the photovoltaic cells 34, the filler layer 35 and the back sheet 11 for photovoltaic modules in this order, (2) and a step of laminating to perfect integral molding by a vacuum heat lamination method or the like in which they are integrated by vacuum aspiration and heat pressure joining. In the method for production of the photovoltaic module 31, (a) coating of a heat melt adhesive, a solvent type adhesive, a photocurable adhesive or the like, (b) to the opposing face to the lamination a corona discharge treatment, an ozone treatment, a low-temperature plasma treatment, a glow discharge treatment, an oxidizing treatment, a primer coating treatment, an undercoating treatment, an anchor coating treatment or the like can be carried out for the purpose of achieving the adhesiveness between each layer.

Since the back sheet 11 for photovoltaic modules has high resistance to hydrolysis, gas barrier properties, weather resistance, durability, handleability, ease of manufacture, cost reduction capability and the like in the photovoltaic module 31 as described above, it is excellent in various characteristics such as durability, weather resistance, heat resistance, gas barrier properties, water resistance, strength and the like, reduction in production cost can be promoted. In particular, according to the photovoltaic module 31, owing to the back sheet 11 for photovoltaic modules in which polyethylene is used as the material for forming the front face side resin film 2, and to high adhesiveness of the filler layer 35, durability and operating life can be further promoted. Therefore, the photovoltaic module 31 can be suitably used in fixed roof stationary solar batteries, as well as in solar batteries for small electric equipments such as wrist watches and electric calculators, and the like. Moreover, since the photovoltaic module 31 includes the back sheet 11 for photovoltaic modules having high voltage endurance as described above, the present social demands for photovoltaic system with high system voltage can be satisfied, thereby capable of facilitating reduction in loss of the power generation efficiency.

The system voltage of the photovoltaic system having the photovoltaic module 31 is preferably not lower than 1000 v, and particularly preferably not lower than 1200 V. The system voltage of the photovoltaic system in the range described above can effectively reduce the loss of the power generation efficiency, and can cover enough with the voltage endurance of the back sheet 1 for photovoltaic modules. Meanwhile, the upper limit of the system voltage of the photovoltaic system having the photovoltaic module 31 is preferably approximately 2000 V taking into account realistic aspects and demands for reduction in thickness.

The use of the back sheet for photovoltaic modules of the present invention and the photovoltaic module are not limited to the foregoing embodiments. For example, in addition to the front face side resin film, the voltage endurable film, the barrier film and the back face side resin film, the back sheet for photovoltaic modules may include other layer (a synthetic resin layer, a metal layer, an inorganic oxide layer or the like) or other film laminated therein. By thus laminating other layer or film, various characteristics such as voltage endurance, gas barrier properties, weather resistance, durability and the like can be significantly improved. In addition, according to the back sheet for photovoltaic modules, the front face side resin film, the voltage endurable film, the barrier film and the back face side resin film may be directly laminated without interposing the adhesive layer by means such as extrusion lamination. In addition, the back sheet for photovoltaic modules can also have a barrier film including an inorganic oxide layer laminated on the surface of the substrate film.

Moreover, the front face side resin film, the voltage endurable film, the substrate film, the back face side resin film or the adhesive layer may contain an ultraviolet ray-absorbing agent. By thus including an ultraviolet ray-absorbing agent, the weather resistance and durability of the back sheet for photovoltaic modules can be enhanced. This ultraviolet ray-absorbing agent is not particularly limited and any known agent can be used as long as it is a compound which absorbs an ultraviolet ray, and can efficiently convert it to thermal energy, and is stable against light. Among all, salicylic acid-based ultraviolet ray-absorbing agents, benzophenone-based ultraviolet ray-absorbing agents, benzotriazole-based ultraviolet ray-absorbing agents and cyanoacrylate-based ultraviolet ray-absorbing agents are preferred which exhibit high performance of ultraviolet ray absorption, has favorable miscibility with the substrate polymer, and can be stably present in the substrate polymer. One, or two or more selected from these groups may be used. Also, as the ultraviolet ray-absorbing agent, a polymer having an ultraviolet ray-absorbing group in the molecular chain (for example, "UW UV " series, Nippon Shokubai Co., Ltd., and the like) may be suitably used. According to the use of such a polymer having an ultraviolet ray-absorbing group in the molecular chain, high miscibility with the polymer of the synthetic resin layer may be achieved, and deterioration of the ultraviolet ray-absorbing function caused by bleeding out of the ultraviolet ray-absorbing agent can be prevented.

The lower limit of the content of the ultraviolet ray-absorbing agent is preferably 0.1% by weight, more preferably 1% by weight, and still more preferably 3% by weight, while the upper limit of the content of the ultraviolet ray-absorbing agent is preferably 10% by weight, more preferably 8% by weight, and still more preferably 5% by weight. When the amount of the blended ultraviolet ray-absorbing agent is less than the aforementioned lower limit, the ultraviolet ray-absorbing function of the back sheet for photovoltaic modules may not be efficaciously achieved, in contrast, when the amount of the blended ultraviolet ray-absorbing agent is greater than the aforementioned upper limit, deleterious influence may be exerted on the matrix polymer of the film or layer, which may lead to reduction in the strength, durability and the like.

Furthermore, the front face side resin film, the voltage endurable film, the substrate film, the back face side resin film or the adhesive layer can also contain a polymer in which an ultraviolet ray-stabilizing group is bound to an ultraviolet ray-stabilizing agent or the molecule chain the radical, active oxygen and the like generated by the ultraviolet ray are inactivated by this ultraviolet ray-stabilizing agent or ultraviolet ray-stabilizing group, thereby capable of improving the ultraviolet ray stability, weather resistance and the like of the back sheet for photovoltaic modules. As this ultraviolet ray-stabilizing agent or ultraviolet ray-stabilizing group, a hindered amine based ultraviolet ray-stabilizing agent or a hindered amine-based ultraviolet ray-stabilizing, group that is highly stable to ultraviolet rays may be suitably used.

Furthermore, the front face side resin film, the voltage endurable film, the substrate film, the back face side resin film or the adhesive layer may contain an antistatic agent. Through including an antistatic agent in such a manner, an antistatic effect is achieved on the the back sheet for photovoltaic modules, thereby resulting in ability to prevent disadvantages caused by electrification with static electricity such as attraction of dust, getting into a difficulty in overlaying with a photovoltaic cell or the like, and the like. Although coating of the antistatic agent on a surface results in stickiness or pollution of the surface, such negative effects may be reduced by including it in the film or layer. The antistatic agent is not particularly limited, and examples thereof which may be used include e.g., anionic antistatic agents such as alkyl sulfate, alkyl phosphate and the like; cationic antistatic agents such as quaternary ammonium salts, imidazoline compounds and the like; nonionic antistatic agents such as polyethylene glycol-based compounds, polyoxyethylene sorbitan monostearate esters, ethanol amides and the like; polymeric antistatic agents such as polyacrylic acid, and the like. Among them, cationic antistatic agents are preferred having comparatively strong antistatic effects, which may exert an anti-static effect by merely adding in a small amount.

### EXAMPLES

Hereinafter, the present invention will be explained in detail by way of Examples, however, the present invention should not be construed as being limited to the description of these Examples to be used.

### Example 1 (not belonging to the invention)

A white polyethylene film having a thickness of 100 µm as the front face side resin film, a polyethylene terephthalate film having a thickness of 12 µm including aluminum oxide having a thickness of 400 Å vapor deposited on the back face by vacuum evaporation as the barrier film, and a polyethylene terephthalate film having a thickness of 188 µm as the back face side resin film were used. A back sheet for photovoltaic modules of Example 1 was obtained by laminating to adhere each of these films by dry lamination using a polyurethane-based adhesive (amount of lamination calculated based on the solid content; 3.5 g/m²).

### Comparative Example 1

A back sheet for photovoltaic modules of Comparative Example 1 was obtained in a similar manner to the above Example 1 except that a white polyethylene terephthalate film having a thickness of 50 µm was used as the front face side resin film.

### Comparative Example 2

A back sheet for photovoltaic modules of Comparative Example 2 was obtained in a similar manner to the above Example 1 except that an ethylene-vinyl acetate copolymer (EVA) film having a thickness of 300 µm was used as the front face side resin film.

### Evaluation of Characteristics

Using the back sheet for photovoltaic modules of Example 1, and the back sheets for photovoltaic modules of Comparative Examples 1 and 2, an adhesion force test for evaluating the adhesiveness of these back sheets for photovoltaic modules to the filler of the photovoltaic module, a saturated pressure cooker test (saturated vapor pressurization test) for evaluating the weather resistance (resistance to hydrolysis), and a partial discharge test (Example 1 alone) for evaluating the voltage endurance were performed. The results are shown in Table 1 below.

In the aforementioned adhesion force test, a glass substrate, a filler consisting of an ethylene-vinyl acetate copolymer (EVA), and the back sheet for photovoltaic modules were first pasted under a condition at 150°C x 20 min with a vacuum laminating machine (manufactured by NPC Incorporated), and using a tensile tester, peel force of the back sheet for photovoltaic modules was measured under a condition of detachment at 180 degree, and at a detachment rate of 0.3 m/min.

The saturated pressure cooker test was performed by leaving the sample to stand under a condition of the temperature of 125°C and 2 atm, and evaluating after the lapse of a predetermined time as:
(1) A: when the strength was retained; and
(2) B: when the strength was nor retained due to deterioration.

The partial discharge test was performed by a method according to IEC60664.

**Table 1**

| Results of Peel Force Test and Saturated Pressure Cooker Test, and Results of Partial Discharge Test | | | | | |
|---|---|---|---|---|---|
| | Peel Force Test Results (gf/mm) | Saturated Pressure Cooker Test Results | | | Partial Discharge Test Results (volt) |
| | | 50 hrs | 100 hrs | 200 hrs | |
| Example 1 | Material Broken | A | A | A | 1265 V |
| Comparative Example 1 | 615 | B | B | B | |
| Comparative Example 2 | Material Broken | A | A | B | |

In Table, the term "broken" means the case in which the adhesion force is so great that the sheet is broken before detachment.

As shown in Table 1 above, the back sheet for photovoltaic modules of Example 1 in which a polyethylene film was used as the front face side resin film had greater adhesiveness to the EVA filler as compared with the back sheet for photovoltaic modules of Comparative Example 1 in which a polyethylene terephthalate film was used. Moreover, the back sheet for photovoltaic modules of Example 1 in which a polyethylene film was used as the front face side resin film exhibited more favorable weather resistance (resistance to hydrolysis) as compared with the back sheet for photovoltaic modules of Comparative Example 2 in which an EVA film was used. Furthermore, the back sheet for photovoltaic modules of Example 1 had high voltage endurance, therefore, it can be applied to the photovoltaic module for photovoltaic systems with the system voltage of not lower than 1000 V.

### Resistance to Hydrolysis of PEN film, and Voltage Endurance Evaluation Test of Voltage Endurable Film

### Reference Example 1

A white polyethylene terephthalate film having a thickness of 50 µm as the front face side resin film, a polyethylene terephthalate film having a thickness of 125 µm as the voltage endurable film, a polyethylene terephthalate film having a thickness of 12 µm including aluminum oxide having a thickness of 400 Å vapor deposited on the back face by vacuum evaporation as the barrier film, and a polyethylene naphthalate film having a thickness of 25 µm as the back face side resin film were used. A back sheet for photovoltaic modules of Reference Example 1 was obtained by laminating to adhere each of these films by dry lamination using a polyurethane-based adhesive (amount of lamination calculated based on the solid content; 4 g/m²) .

### Reference Example 2

A back sheet for photovoltaic modules of Reference Example 2 was obtained in a similar manner to the above Reference Example 1 except that a polyethylene terephthalate film having a thickness of 188 µm was used as the voltage endurable film.

### Reference Example 3

A back sheet for photovoltaic modules of Reference Example 3 was obtained in a similar manner to the above Reference Example 1 except that a polyethylene terephthalate film having a thickness of 100 µm was used as the voltage endurable film.

### Reference Example 4

A back sheet for photovoltaic modules of Reference Example 4 was obtained in a similar manner to the above Reference Example 1 except that the voltage endurable film was omitted.

### Reference Example 5

A back sheet for photovoltaic modules of Reference Example 5 was obtained in a similar manner to Reference Example 1 except that a polyethylene terephthalate film having a thickness of 188 µm was used as the back face side resin film.

### Evaluation of Characteristics

Using the back sheets for photovoltaic modules of Reference Examples 1 to 5, on these back sheets for photovoltaic modules, the saturated pressure cooker test (saturated vapor pressurization test) for evaluating the weather resistance (resistance to hydrolysis), and the partial discharge test for evaluating the voltage endurance were performed. The results are shown in Table 2 below.

**Table 2**

| Results of Saturated Pressure Cooker Test, and Results of Partial Discharge Test | | | | |
|---|---|---|---|---|
| | Saturated Pressure Cooker Test Results | | | Partial Discharge Test Results (volt) |
| | 50 hrs | 100 hrs | 200 hrs | |
| Reference Example 1 | A | A | A | ≈ 1000V |
| Reference Example 2 | A | A | A | ≈ 1200V |
| Reference Example 3 | A | A | A | ≈ 950V |
| Reference Example 4 | A | A | A | ≈ 600V |
| Reference Example 5 | A | B | B | ≈ 1000V |

As shown in Table 2 above, the back sheets for photovoltaic modules of Reference Examples 1, 2 and 3 in which a polyethylene naphthalate film was used as the back face side resin film exhibited more favorable weather resistance (resistance to hydrolysis) as compared with the back sheet for photovoltaic modules of Reference Example 5 in which a polyethylene terephthalate film was used. Furthermore, the back sheets for photovoltaic modules of Reference Examples 1, 2 and 3 high voltage endurance as compared with the back sheet for photovoltaic modules of Reference Example 4 without including the voltage endurable film, and in particular, the back sheets for photovoltaic modules of Reference Examples 1, and 2 can be applied to the photovoltaic module for photovoltaic systems with the system voltage of not lower than 1000 V.

### INDUSTRIAL APPLICABILITY

As described hereinabove; the back sheet for photovoltaic modules of the present invention, and a photovoltaic module using the same are useful as a component of solar batteries, and in particular they can be suitably used in fixed roof stationary solar batteries which have been increasingly becoming popular, as well as in solar batteries for small electric equipments such as electric calculators, and the like.

## Claims

1. Use of a back sheet (1, 11, 21) for photovoltaic modules (31) that is a laminate comprising:
- a front face side resin film (2),
- a voltage endurable film (12),
- a barrier film (3, 22) and
- a back face side resin film (4) in this order,
wherein:
- the front face side resign film (2) comprises polyethylene as a principal component
- the voltage endurable film (12) comprises polyethylene terephthalata as a principal component, **characterized in that**
- the voltage endurable film (12) has a thickness of 50 µm or greater and 250 µm or less, whereby the banks film (3, 22) has a lower thickness than the voltage endurable film (12) wherein the barrier film (3): has a substrate film (6) with a thickness between 7 µm and 20 µm and an inorganic oxide layer (7) with a thickness between 3 Å and 3000 Å̊; or
an aluminum foil with a thickness between 6 µm and 30 µm is used as the barrier flim (22), whereby the back sheet (1, 11, 21) is to be attached so that the front face side resin film (2) is inwardly arranged in the photovoltaic module (31) and the back face side resin film (4) is outwardly arranged in the photovoltaic module (31).

2. Use of the back sheet (1, 11, 21) for photovoltaic modules (31) according to the claim 1 wherein each film (2, 3, 4, 12, 22) constructing the laminate la laminated via an adhesive layer (5).

3. Use of the back sheet (1, 11, 21) for photovoltaic modules (31) according to claim 2 wherein a polyurethane-based adhesive is used as the adhesive that constitutes the adhesive layer (5).

4. Use of the back sheet (1, 11, 21) for photovoltaic modules (31) according to one of the preceding claims wherein the back face side resin film (4) comprises polyethylene naphthalate or polyethylene terephthalate as a principal component.

5. Use of the back sheet (1, 11) for photovoltaic modules (31) according to claim 1 wherein the substrate film (6) of the barrier film (3) comprises polyethylene terephthalate as a principal component.

6. Use of the back sheet (1, 11) for photovoltaic modules (31) according to claim 1 wherein aluminium oxide or silica oxide is used as the inorganic oxide that constitutes the inorganic oxide layer (7).

7. Use of the back sheet (1, 11, 21) for photovoltaic modules (31) according to one of the preceding claims wherein a pigment is included to be dispersed in the front face side resin film (2).

8. A photovoltaic module (31) comprising a fight-transmissive substrate (32), a filler layer (33), a photovoltaic cell (34) as a photovoltaic device, a filler layer (35), and the back sheet (1, 11, 21) for photovoltaic modules according to claim 1 laminated in the order.

9. The photovoltaic module (31) according to claim 8 wherein each film (2, 3, 4, 12, 22) constructing the laminate is laminated via an adhesive layer (5).

10. The photovoltaic module (31) according to claim 9 wherein a polyurethane-based adhesive is used as the adhesive that constitutes the adhesive layer (5).

11. The photovoltaic module (31) according to one of the preceding photovoltaic module claims wherein the back face side resin film (4) comprises polyethylene naphthalate or polyethylene terephthalate as a principal component.

12. The photovoltaic module (31) according to claim 8 wherein the substrate film (6) of the barrier film (3) comprises polyethylene terephthalate as a principal component.

13. The photovoltaic module (31) according to claim 8 wherein aluminum oxide or silica oxide is used as the inorganic oxide that constitutes the inorganic oxide layer (7).

14. The photovoltaic module (31) according to one of the preceding photovoltaic module (31) claims wherein a pigment is included to be dispersed in the front face side resin film (2).

## Patentansprüche

1. Verwendung einer Rückseitenlage (1, 11, 21) für Photovoltaikmodule (31), wobei diese ein Laminat darstellt, umfassend:
- eine frontflächenseitige Kunstharzschicht (2),
- eine spannungsfeste Schicht (12),
- eine Barriereschicht (3, 22) und
- eine rückflächenseitige Kunstharzschicht (4), in dieser Reihenfolge,
wobei:
- die frontflächenseitige Kunstharzschicht (2) als Hauptbestandteil Polyethylen umfasst,
- die spannungsfeste Schicht (12) als Hauptbestandteil Polyethylenterephthalat umfasst,
**dadurch gekennzeichnet, dass**
die spannungsfeste Schicht (12) eine Dicke von 50 µm oder mehr und 250 µm oder weniger aufweist, wobei die Barriereschicht (3, 22) eine geringere Dicke als die spannungsfeste Schicht (12) aufweist, wobei die Barriereschicht (3) eine Substratschicht (6) mit einer Dicke zwischen 7 µm und 20 µm und eine anorganische Oxidschicht (7) mit einer Dicke zwischen 3 Å; und 3000 Å; aufweist oder eine Aluminiumfolie mit einer Dicke zwischen 6 µm und 30 µm als die Barriereschicht genutzt wird, wobei die Rückseitenlage (1, 11, 21) derart anzubringen ist, dass die frontflächenseitige Kunstharzschicht (2) in dem Photovoltaikmodule (31) nach innen hin angeordnet ist und die rückflächenseitige Kunstharzschicht (4) in dem Photovoltaikmodule (31) nach außen hin angeordnet ist.

2. Verwendung der Rückseitenlage (1, 11, 21) für Photovoltaikmodule (31) nach Anspruch 1, wobei jede das Laminat bildende Schicht (2, 3, 4, 12, 22) über eine Adhäsivschicht (5) laminiert ist.

3. Verwendung der Rückseitenlage (1, 11, 21) für Photovoltaikmodule (31) nach Anspruch 2, wobei ein Adhäsiv auf Polyurethan-Basis als das die Adhäsivschicht (5) bildende Adhäsiv genutzt wird.

4. Verwendung der Rückseitenlage (1, 11, 21) für Photovoltaikmodule (31) nach einem der vorhergehenden Ansprüche, wobei die rückflächenseitige Kunstharzschicht (4) als einen Hauptbestandteil Polyethylennaphthalat oder Polyethylenterephthalat umfasst.

5. Verwendung der Rückseitenlage (1, 11) für Photovoltaikmodule (31) nach Anspruch 1, wobei die Substratschicht (6) der Barriereschicht (3) als einen Hauptbestandteil Polyethylenterephthalat umfasst.

6. Verwendung der Rückseitenlage (1, 11) für Photovoltaikmodule (31) nach Anspruch 1, wobei Aluminiumoxid oder Siliciumoxid als das die anorganische Oxidschicht (7) bildende anorganische Oxid genutzt wird.

7. Verwendung der Rückseitenlage (1, 11, 21) für Photovoltaikmodule (31) nach einem der vorhergehenden Ansprüche, wobei ein Pigment derart integriert wird, dass es in der frontflächenseitigen Kunstharzschicht (2) dispergiert ist.

8. Photovoltaikmodul (31), das ein lichtdurchlässiges Substrat (32), eine Filterschicht (33), eine Photovoltaikzelle (34) als photovoltaisches Bauelement, eine Filterschicht (35) und eine Rückseitenlage (1, 11, 21) für Photovoltaikmodule gemäß Anspruch 1 umfasst, die in dieser Reihenfolge laminiert sind.

9. Photovoltaikmodul (31) nach Anspruch 8, wobei jede das Laminat bildende Schicht (2, 3, 4, 12, 22) über eine Adhäsivschicht (5) laminiert ist.

10. Photovoltaikmodul (31) nach Anspruch 9, wobei ein Adhäsiv auf Polyurethan-Basis als das die Adhäsivschicht (5) bildende Adhäsiv genutzt wird.

11. Photovoltaikmodul (31) nach einem der vorhergehenden Photovoltaikmodul-Ansprüche, wobei die rückflächenseitige Kunstharzschicht (4) als einen Hauptbestandteil Polyethylennaphthalat oder Polyethylenterephthalat umfasst.

12. Photovoltaikmodul (31) nach Anspruch 8, wobei die Substratschicht (6) der Barriereschicht (3) als einen Hauptbestandteil Polyethylenterephthalat umfasst.

13. Photovoltaikmodul (31) nach Anspruch 8, wobei Aluminiumoxid oder Siliciumoxid als das die anorganische Oxidschicht (7) bildende anorganische Oxid genutzt wird.

14. Photovoltaikmodul (31) nach einem der vorhergehenden Photovoltaikmodul-Ansprüche, wobei ein Pigment derart integriert ist, dass es in der frontflächenseitigen Kunstharzschicht (2) dispergiert ist.

## Revendications

1. Utilisation d'une feuille arrière (1, 11, 21) pour modules photovoltaïques (31) qui est un stratifié comprenant :
- un film de résine côté face avant (2),
- un film résistant à la tension (12),
- un film-barrière (3, 22) et
- un film de résine côté face arrière (4) dans cet ordre,
dans laquelle
- le film de résine côté face avant (2) comprend du polyéthylène comme composant principal
- le film résistant à la tension (12) comprend du polyéthylène téréphtalate comme composant principal, **caractérisée en ce que**
- le film résistant à la tension (12) a une épaisseur de 50 µm ou plus et de 250 µm ou moins, moyennant quoi le film barrière (3, 22) a une épaisseur inférieure à celle du film résistant à la tension (12),
dans laquelle le film barrière (3) comporte un film de substrat (6) d'une épaisseur comprise entre 7 µm et 20 µm et une couche d'oxyde inorganique (7) d'une épaisseur comprise entre 3 Å; et 3000 Å; ; et une feuille d'aluminium d'une épaisseur comprise entre 6 µm et 30 µm est utilisée comme film barrière (22), moyennant quoi la feuille arrière (1, 11, 21) doit être fixée de sorte que le film de résine côté face avant (2) soit agencé vers l'intérieur dans le module photovoltaïque (31) et que le film de résine côté face arrière (4) soit agencé vers l'extérieur dans le module photovoltaïque (31).

2. Utilisation de la feuille arrière (1, 11, 21) pour modules photovoltaïques (31) selon la revendication 1, dans laquelle chaque film (2, 3, 4, 12, 22) constituant le stratifié est stratifié par l'intermédiaire d'une couche adhésive (5).

3. Utilisation de la feuille arrière (1, 11, 21) pour modules photovoltaïques (31) selon la revendication 2, dans laquelle un adhésif à base de polyuréthane est utilisé en tant qu'adhésif constituant la couche adhésive (5).

4. Utilisation de la feuille arrière (1, 11, 21) pour modules photovoltaïques (31) selon l'une des revendications précédentes, dans laquelle le film de résine côté face arrière (4) comprend du polyéthylène naphtalate ou du polyéthylène téréphtalate comme composant principal.

5. Utilisation de la feuille arrière (1, 11) pour modules photovoltaïques (31) selon la revendication 1, dans laquelle le film de substrat (6) du film barrière (3) comprend du polyéthylène téréphtalate comme composant principal.

6. Utilisation de la feuille arrière (1, 11) pour modules photovoltaïques (31) selon la revendication 1, dans laquelle de l'oxyde d'aluminium ou de l'oxyde de silice est utilisé comme oxyde inorganique constituant la couche d'oxyde inorganique (7).

7. Utilisation de la feuille arrière (1, 11, 21) pour modules photovoltaïques (31) selon l'une des revendications précédentes, dans laquelle un pigment est inclus pour être dispersé dans le film de résine côté face avant (2).

8. Module photovoltaïque (31) comprenant un substrat de transmission de lumière (32), une couche-filtre (33), une cellule photovoltaïque (34) en tant que dispositif photovoltaïque, une couche-filtre (35), et la feuille arrière (1, 11, 21) pour modules photovoltaïques selon la revendication 1 stratifiées dans cet ordre.

9. Module photovoltaïque (31) selon la revendication 8, dans lequel chaque film (2, 3, 4, 12, 22) constituant le stratifié est stratifié par l'intermédiaire d'une couche adhésive (5).

10. Module photovoltaïque (31) selon la revendication 9, dans lequel un adhésif à base de polyuréthane est utilisé en tant qu'adhésif constituant la couche adhésive (5).

11. Module photovoltaïque (31) selon l'une des revendications de module photovoltaïque précédentes, dans lequel le film de résine côté face arrière (4) comprend du polyéthylène naphtalate ou du polyéthylène téréphtalate comme composant principal.

12. Module photovoltaïque (31) selon la revendication 8, dans lequel le film de substrat (6) du film-barrière (3) comprend du polyéthylène téréphtalate comme composant principal.

13. Module photovoltaïque (31) selon la revendication 8, dans laquelle de l'oxyde d'aluminium ou de l'oxyde de silice est utilisé comme oxyde inorganique constituant la couche d'oxyde inorganique (7).

14. Module photovoltaïque (31) selon l'une des revendications de module photovoltaïque (31) précédentes, dans laquelle un pigment est inclus pour être dispersé dans le film de résine côté face avant (2).
